Europäisches Patentamt

European Patent Office

Office européen des brevets

(11) Veröffentlichungsnummer: **0 277 336**
**A1**

(12) **EUROPÄISCHE PATENTANMELDUNG**

(21) Anmeldenummer: **87118882.7**

(22) Anmeldetag: **19.12.87**

(51) Int. Cl.4: **H01L 29/167** , H01L 29/40 , H01L 29/44

(30) Priorität: **13.01.87 CH 92/87**

(43) Veröffentlichungstag der Anmeldung:
**10.08.88 Patentblatt 88/32**

(84) Benannte Vertragsstaaten:
**BE CH DE FR GB IT LI NL SE**

(71) Anmelder: **BBC Brown Boveri AG**
**Haselstrasse**
**CH-5401 Baden(CH)**

(72) Erfinder: **Veitz, Rudolf**
**Im Tobelacher 11**
**CH-5406 Baden(CH)**
Erfinder: **Zimmermann, Wolfgang, Dr.**
**Rottrottenweg 24**
**CH-5313 Klingnau(CH)**

(54) **Verfahren zur Herstellung eines schnellen Halbleiterbauelements.**

(57) Bei der Herstellung von Leistungshalbleitern mit eindiffundierten Fremdatomen zur Verringerung der Trägerlebensdauer und hochdotierten Uebergangsschichten (6, 8) zwischen den metallischen Kontakten (7, 9) und dem Innern des Substrats (1) werden die Uebergangsschichten (6, 8) wenigstens teilweise unter Anwendung der Ionenimplantation hergestellt.

Damit werden die mit der bei herkömmlicher Gasphasen-Abscheidung auftretenden Glasbildung verbundenen Inhomogenitäten vermieden, die zu einer erhöhten Streuung der dynamischen Werte bei den fertigen Bauelementen führen.

EP 0 277 336 A1

FIG.1K

## VERFAHREN ZUR HERSTELLUNG EINES HALBLEITERBAUELEMENTS

TECHNISCHES GEBIET

Die Erfindung bezieht sich auf das Gebiet der Halbleitertechnologie. Sie betrifft speziell ein Verfahren zur Herstellung eines Halbleiterbauelements, insbesondere einer Leistungsdiode oder eines Leistungsthyristors, wobei das Halbleiterbauelement zwischen metallischen Kontakten in einem Substrat eine Mehrzahl von unterschiedlich dotierten Zonen aufweist, die wenigstens einen pn-Uebergang bilden, bei welchem Verfahren die folgenden Schritte vorgesehen sind:
- zum Zwecke der leichteren Injektion von Ladungsträgern aus den metallischen Kontakten in das Substrat wird durch das Einbringen eines geeigneten Dotierstoffs wenigstens unter einem der metallischen Kontakte eine hochdotierte Uebergangsschicht erzeugt; und
- zur Verringerung der Trägerlebensdauer werden in das Innere des Substrats Fremdatome als Rekombinationszentren eingebracht.

STAND DER TECHNIK

Leistungs-Halbleiterbauelemente (Dioden, Thyristoren, rückwärtsleitende Thyristoren, GTOs usw.) erfordern zum Zwecke der leichten Injektion aus den metallischen Kontakten in das Substrat Uebertragungsschichten mit n -und p -Dotierungsprofilen. Diese Dotierungsprofile bewirken, dass die Uebergangswiderstände von der Metallisierung in das Innere des Silizium-Wafers klein werden und entsprechend die für den Stromtransport erforderlichen Ueberschuss-Ladungsträger leicht injiziert werden können.

Es ist nun bekannt, diese n -und p -Dotierungsprofile in den Uebergangsschichten durch Diffusion von geeigneten Dotierstoffen (für n -Dotierung: P, As; für p -Dotierung: B) in das Substrat einzubringen.

Dies geschieht üblicherweise, indem zunächst die Dotierstoffe (P, As, B) aus der Gasphase auf dem Silizium-Wafer abgeschieden werden (predeposition) und dann im gleichen oder einem oder mehreren anschliessenden Prozessen durch Diffusion soweit in das Innere einzutreiben, dass die erwünschte leichte Trägerinjektion erreicht wird (drive-in).

Bei der angeführten Abscheidung der Dotierstoffe aus der Gasphase bilden sich oberflächlich glasartige Verbindungen, die im Silizium-Kristallgitter des Substrats Kristalldefekte hervorrufen. Solche Kristalldefekte können leicht durch geeignete Aetzverfahren sichtbar gemacht werden.

Die oberflächlichen Glasschichten selbst und/oder die durch sie im darunterliegenden Silizium-Substrat erzeugten Kristalldefekte üben bereits bei der Abscheidung und natürlich auch bei nachfolgenden Temperaturbehandlungen des Substrats eine Getterwirkung auf Verunreinigungen (Fremdatome) im Silizium-Wafer aus, d.h., sie bewirken beispielsweise, dass im Innern des Substrats befindliche Fremdatome an der Oberfläche eingegraben und somit effektiv aus dem Innern entfernt werden.

Derartige Fremdatome, z.B. Gold, haben einen sehr starken Einfluss auf die dynamischen Eigenschaften des fertigen Halbleiterbauelements. Sie werden teilweise unabsichtlich, normaler weise aber absichtlich und gezielt eindiffundiert, um diese dynamischen Eigenschaften (Einschalt-und Abschaltverhalten) günstig zu beeinflussen.

So wird beispielsweise die bei einer schnellen Leistungsdiode mit einer Sperrspannung ($V_{DRM}$) von 1400 V geforderte Sperrverzögerungszeit $t_{rr}$ von 1,5 bis 3 $\mu$s durch eine Gold-Diffusion bei einer Temperatur von über 800 °C über einen längeren Zeitraum eingestellt.

Die Diffusionsbedingungen für die als Rekombinationszentren wirksamen Fremdatome müssen insgesamt entsprechend den geforderten dynamischen Eigenschaften des jeweiligen Halbleiterbauelements (Diode, Thyristor usw.) gewählt werden.

Es ist nun bekannt und nachweisbar, dass die Abscheidebedingungen bei dem "predeposition"-Schritt einen wesentlichen Einfluss auf die Glas- bzw. Kristalldefektbildung und damit auch auf die beschriebene Getterwirkung haben. Dabei kann die Getterwirkung sowohl darin bestehen, dass Fremdatome aus dem Innern des Substrats bleibend entfernt werden, als auch darin, dass eine beabsichtigte Eindiffusion von Fremdatomen erschwert wird.

Da die übliche Abscheidung aus der Gasphase einem Strömungsprozess entspricht, sind Inhomogenitäten in der Abscheidung nicht zu vermeiden. Solche Inhomogenitäten führen über die Getterwirkung zu einer entsprechend inhomogenen Fremdatom-Verteilung im Substrat und sind damit ursächlich für nicht optimale und streuende dynamische Daten der Bauelemente. Diese Streuung in den dynamischen Eigenschaften betrifft sowohl die Menge der Silizium-Wafer eines Fertigungsloses, als auch die Verhältnisse auf einem einzelnen Silizium-Wafer.

## DARSTELLUNG DER ERFINDUNG

Es ist nun Aufgabe der Erfindung, ein Verfahren zur Herstellung von Halbleiterbauelementen anzugeben, welches eine deutliche Einengung der Streuung der dynamischen Eigenschaften dieses Halbleiterbauelemente ermöglicht.

Die Aufgabe wird bei einem Verfahren der eingangs genannten Art dadurch gelöst, dass zum Einbringen des Dotierstoffs für die hochdotierte Uebergangsschicht das Verfahren der Ionenimplantation Anwendung findet.

Der Kern der Erfindung besteht also darin, die einem inhomogenen Strömungsprozess entsprechende Abscheidung aus der Gasphase durch eine gut steuerbare, sehr gleichmässige Implantation zu ersetzen.

Gemäss einer bevorzugten Ausgestaltung der Erfindung wird beim Erzeugen der hochdotierten Uebergangsschicht in einem ersten Schritt der Dotierstoff mittels der Ionenimplantation in eine oberflächennahe Prädepositionsschicht eingebracht und in einem zweiten Schritt der Dotierstoff aus der Prädepositionsschicht durch Diffusion bis zur gewünschten Tiefe der Uebergangsschicht in das Substrat eingetrieben.

Weitere Ausgestaltungen und Ausführungsbeispiele ergeben sich aus den Unteransprüchen.

## KURZE BESCHREIBUNG DER ZEICHNUNGEN

Die Erfindung soll nachfolgend anhand von Ausführungsbeispielen im Zusammenhang mit der Zeichnung näher erläutert werden.

Es zeigen:

Fig. 1A-D, F-K verschiedene Stadien bei der Herstellung einer schnellen Leistungsdiode nach dem Stand der Technik;

Fig. 1E gemäss einer Ausgestaltung der Erfindung den Implantationsschritt, der die in Fig. 1F und 1G dargestellten Schritt des bekannten Verfahrens ersetzt;

Fig. 2 dynamische Daten einer Serie von Bauelementen, die nach dem bekannten Verfahren hergestellt worden sind; und

Fig. 3 entsprechend Daten für Bauelemente, die nach dem erfindungsgemässen Verfahren hergestellt worden sind.

## WEGE ZUR AUSFÜHRUNG DER ERFINDUNG

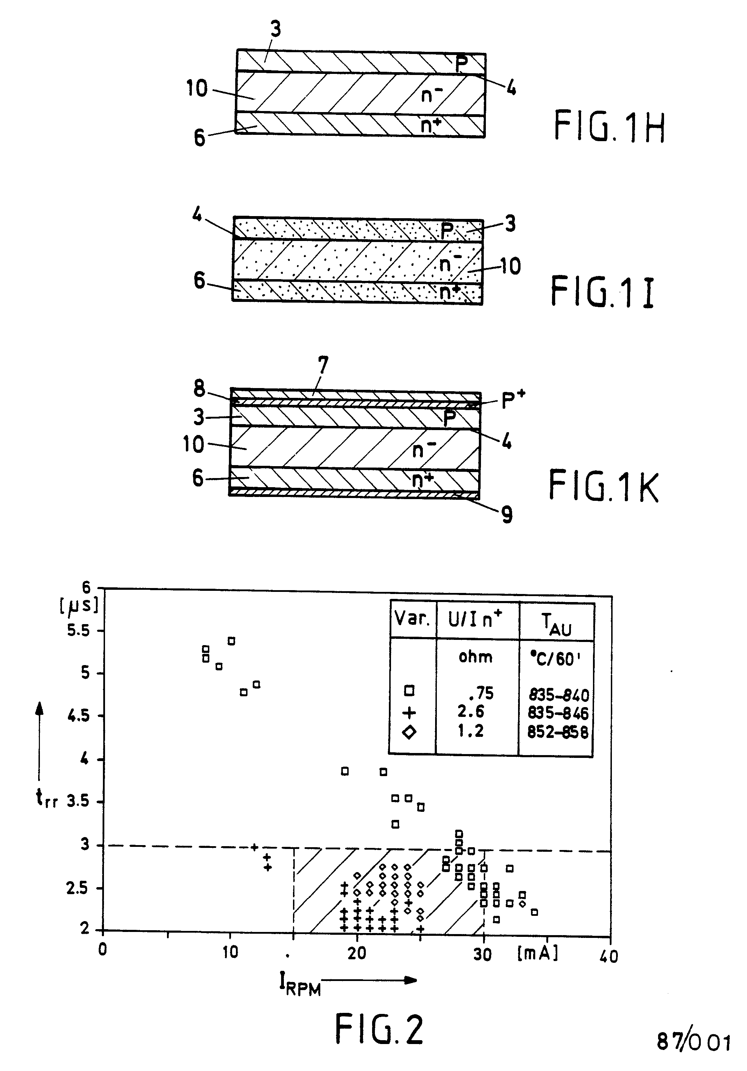

Die Erfindung wird im folgenden dem Beispiel eines Herstellungsprozesses für schnelle Leistungsdioden erläutert. Die verschiedenen Stadien dieses Prozesses sind in den Fig. 1A bis 1E dargestellt.

Bei der Herstellung dieser Leistungsdioden wird ausgegangen von einem Substrat 1 (Fig. 1A) aus gleichmässig neutronendotiertem n⁻-Silizium mit einem spezifischen Widerstand von z.B. 40Ωcm. Die oben und unten liegenden Hauptflächen dieses Substrats sind Sägeflächen, die vor der Weiterverarbeitung des Wafers zunächst geläppt und dann durch Aetzen um mehrere Mikrometer abgetragen werden, um durch das Läppen entstandene Beschädigungen zu vermeiden.

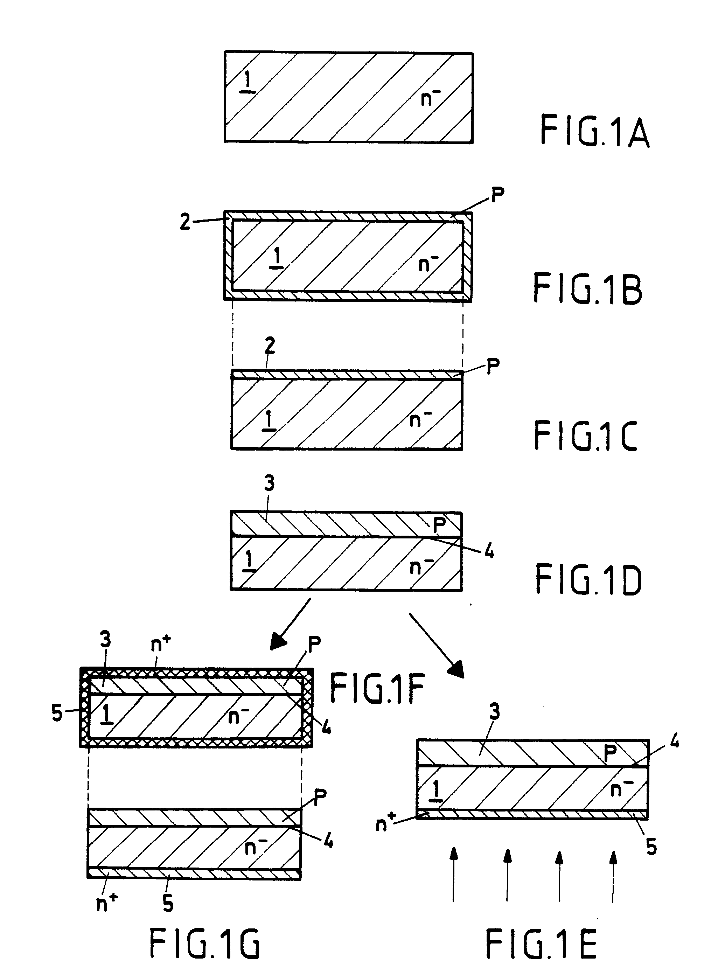

In das so vorbereitete Substrat 1 wird in einem ersten Schritt (Fig. 1B) durch Einbringen von Al eine allseitige oberflächennahe Prädepositionsschicht 2 erzeugt, welche p-dotiert ist. Die Prädepositionsschicht 2 hat beispielsweise eine Tiefe von etwa 10 μm.

In einem zweiten Schritt (Fig. 1C) wird durch Abätzen von etwa 15 μm Substratmaterial die Prädepositionsschicht 2 bis auf eine der Hauptflächen vom Substrat 1 entfernt.

Die auf der einen Hauptfläche verbliebene Prädepositionsschicht 2 dient in einem dritten Schritt als Quelle für die weitere Eindiffusion (drive-in) der Al-Atome, die bei einer Temperatur von mehr als 1200 °C über etwa 6 h Dauer in einer oxidierenden Atmosphäre durchgeführt wird und eine tief ins Substrat 1 hineinreichende p-Zone 3 (Fig. 1D) aufbaut, die mit dem n⁻-dotierten Substrat-Grundmaterial einen pn-Uebergang 4 bildet.

An dieser Stelle des Herstellungsprozesses verzweigen sich bei dem gewählten Verfahrensbeispiel nun der bekannte Verfahrensablauf und der Verfahrensablauf nach der Erfindung (in der Zeichnung ist diese Verzweigung durch die in unterschiedliche Richtungen weisenden Pfeile angedeutet).

Beim bekannten Verfahrensablauf (Fig. 1F und 1G) wird durch Abscheidung von Phosphor aus der Gasphase auf dem Silizium-Wafer allseitig eine etwa 5 m dicke n⁺-dotierte Prädepositionsschicht 5 von glasartiger Beschaffenheit erzeugt. Nach einem durch Aetzen bewirkten Materialabetrag von etwa 8 μm bleibt die n⁺-dotierte Prädepositionsschicht 5 nur auf der anderen Hauptfläche erhalten (Fig. 1G).

Beim Verfahrensablauf nach der Erfindung (Fig. 1E) wird die oberflächennahe, n⁺-dotierte Prädepositionsschicht 5 durch kontrollierte und gerichtete Implantation von Phosphoratomen in das Substrat 1 erzeugt (angedeutet durch die Pfeile in Fig. 1E).

Die auf die Erzeugung der n⁺-dotierten Prädepositionsschicht 5 folgenden Schritte (Fig. 1H bis 1K) sind beiden Verfahrensabläufen im wesentlichen wieder gemeinsam: Dazu gehört das Eintreiben der Phosphoratome aus der n⁺-dotierten Prädepositionsschicht 5 (als Diffusionsquelle) tiefer in das Substrat 1, wodurch eine n -Uebergangsschicht 6 gebildet wird (Fig. 1H), die etwa 10 μm tief reicht.

Dieser drive-in-Schritt dient beim herkömmlichen Verfahren hauptsächlich dazu, die Konzentration der Phosphoratome an der Oberfläche herabzusetzen. Bei der Ionenimplantation ist der Schritt dagegen unbedingt notwendig, um eine Uebergangsschicht von ausreichender Dicke zu erzeugen, da die implantierten Phosphoratome nur in einer geringen Tiefe unterhalb der Oberfäche sitzen.

Anschliessend werden von allen Seiten Goldatome in den Silizium-Wafer eindiffundiert (Fig. 1I), die als Rekombinationszentren die Trägerlebensdauer gezielt herabsetzen und damit die dynamischen Eigenschaften des Bauelements verbessern, insbesondere die Sperr-verzögerungszeit $t_{rr}$ verkürzen. Die Golddiffusion erfolgt dabei vorzugsweise bei Temperaturen zwischen 800 °C und 860 °C und über einen Zeitraum von etwa 1 h.

Zum Schluss wird das Bauelement mit einem Kathodenkontakt 9 in Form einer Metallisierung und einem Anodenkontakt 7 in Form eines Mo-Legierkontaktes versehen, wobei durch das beim Auflöten verwendete Al eine p -Uebergangsschicht 8 entsteht (Fig. 1K).

Im erläuterten Beispiel sind für die n - Uebergangsschicht Phosphoratome implantiert und eingetrieben worden. Genausogut können dazu auch Arsenatome verwendet werden. Zur Erzeugung einer p -Uebergangsschicht eignen sich entsprechend Boratome.

Für die Implantation von Phosphoratomen hat es sich bewährt, mit einer Dosis von $10^{15}$ -$10^{16}$ Teilchen/cm² und einer Beschleunigung von etwa 170 keV zu arbeiten.

Der an die Implantation anschliessende drive-in-Prozess wird vorzugsweise in einer wasserhaltigen (feuchten) Atmosphäre bei einer Temperatur von etwa 1050 °C über eine Zeit von etwa 2 h durchgeführt.

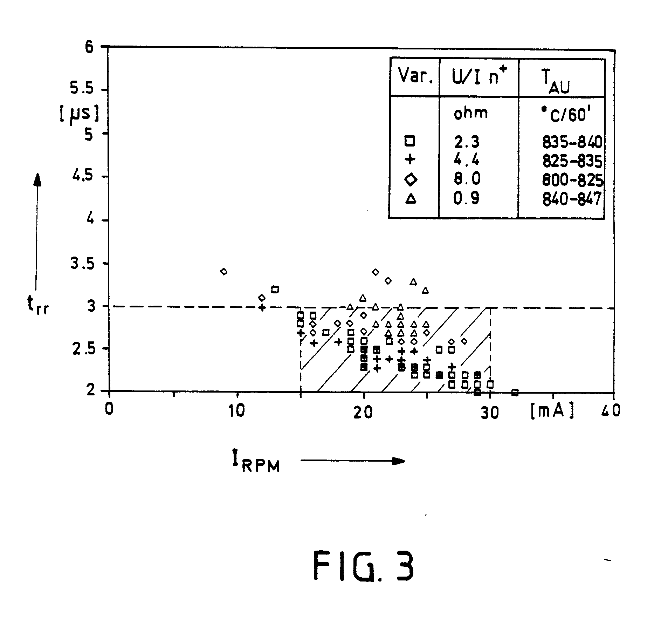

Die Vorteile der Erfindung werden an einem Vergleich der erreichbaren dynamischen Daten und deren Streuung deutlich (Fig. 2 und 3). In Fig. 2 sind die bei 125 °C gemessenen Sperr-verzögerungszeiten $t_{rr}$ über dem Sperratom $I_{RPM}$ bei 2/3 der spezifizierten Sperrspannung $V_{DRM}$ für mehrere Serien von in herkömmlicher Weise hergestellten schnellen Leistungsdioden aufgetragen. Die durch unterschiedliche Symbole (Quadrat, Kreuz, Raute) gekennzeichneten Serien unterscheiden sich durch die bei der Golddiffusion über 60 min verwendete Diffusionstemperatur $T_{Au}$ und einen entsprechenden Widerstand U/I an der Oberfläche der n -Uebergangsschicht gemäss der in die Figur eingefügten Tabelle. Die Abscheidung des Phosphors aus der Gasphase ($POCl_3$) erfolgt hier bei Temperaturen von 890 °C bis 950 °C über einen Zeitraum von etwa 100 min.

In Fig. 3 sind entsprechende Werte für implantierte Leistungsdioden wiedergegeben, bei denen die Implantation und das Eintreiben unter den o.g. bevorzugten Bedingungen durchgeführt wurde.

Wenn man voraussetzt, dass die dynamischen Daten der Dioden möglichst im schraffierten Wertebereich ($t_{rr}$ < 3 μs; 15 mA < $I_{RPM}$ < 30 mA) liegen sollen, erkennt man durch einen Vergleich beider Diagramme sofort, dass die Streuung der Werte bei Dioden nach der Erfindung (Fig. 3) deutlich geringer ist als bei herkömmlichen Dioden (Fig. 2).

Da bei der Ionenimplantation des erfindungsgemässen Verfahrens die für die herkömmliche Gasphasen-Abscheidung unvermeidliche Glasbildung mit ihren Inhomogenitäten unterbleibt, ist mit der Erfindung eine wesentliche Einengung der Streuung in den dynamischen Eigenschaften sowohl auf dem einzelnen Bauelement als auch im gesamten Fertigungslos und von einem Fertigungslos zum anderen zu erreichen.

Darüber hinaus ermöglicht die Ionenimplantation nicht nur eine Homogenisierung der Verhältnisse, sondern zusätzlich auch eine andere und gegebenenfalls optimierte Einstellung des axialen Profils an Rekombinationszentren (z.B. in Form der Goldatome), da die vorhandenen bzw. nicht vorhandenen Gettereigenschaften sich auch auf diese axiale Verteilung auswirken.

Im übrigen wirkt sich die verbesserte Kontrolle der dynamischen Parameter durch die Erfindung auch dahingehend aus, dass die Empfindlichkeit der Bauelementeeigenschaften gegenüber den Bedingungen der Golddiffusion verringert und auf die üblicherweise erforderlichen sog. "Gold-Antests" verzichtet werden kann, was einen wesentlich vereinfachten und verkürzten Fertigungsablauf zur Folge hat.

## Ansprüche

1. Verfahren zur Herstellung eines Halbleiterbauelements, insbesondere einer Leistungsdiode oder eines Leistungsthyristors, wobei das Halbleiterbauelement zwischen metallischen Kontakten (7, 9) in einem Substrat (1) eine Mehrzahl von unterschiedlich dotierten Zonen (3, 10) aufweist, die wenigstens einen pn-Uebergang (4) bilden; bei welchem Verfahren die folgenden Schritte vorgesehen sind:

(a) zum Zwecke der leichteren Injektion von Ladungsträgern aus den metallischen Kontakten (7, 9) in das Substrat (1) wird durch das Einbringen eines geeigneten Dotierstoffs wenigstens unter einem der metallischen Kontakte (7, 9) eine hochdotierte Uebergangsschicht (6) erzeugt; und

(b) zur Verringerung der Trägerlebensdauer werden in das Innere des Substrats (1) Fremdatome als Rekombinationszentren eingebracht; dadurch gekennzeichnet, dass

(c) zum Einbringen des Dotierstoffs für die hochdotierte Uebergangsschicht (6) das Verfahren der Ionenimplantation Anwendung findet.

2. Verfahren nach Anspruch 1, dadurch gekennzeichnet, dass beim Erzeugen der hochdotierten Uebergangsschicht (6) in einem ersten Schritt der Dotierstoff mittels der Ionenimplantation in eine oberflächennahe Prädepositionsschicht (5) eingebracht wird, und in einem zweiten Schritt der Dotierstoff aus der Prädepositionsschicht (5) durch Diffusion bis zur gewünschten Tiefe der Uebergangsschicht (6) in das Substrat (1) eingetrieben wird.

3. Verfahren nach Anspruch 2, dadurch gekennzeichnet, dass

(a) das Substrat (1) aus schwach n-dotiertem Silizium besteht,

(b) als Fremdatome zur Verringerung der Trägerlebensdauer Goldatome in das Substrat (1) eindiffundiert werden; und

(c) zur Erzeugung von n -dotierten Uebergangsschichten Phosphor-oder Arsenatome und zur Erzeugung von p -dotierten Uebergangsschichten Boratome in das Substrat (1) implantiert werden.

4. Verfahren nach Anspruch 3, dadurch gekennzeichnet, dass die Eindiffusion der Goldatome bei Temperaturen zwischen 800 °C und 860 °C und über einen Zeitraum von etwa 1 h erfolgt.

5. Verfahren nach Anspruch 2, dadurch gekennzeichnet, dass

(a) die Uebergangsschicht (6) n -dotiert ist;

(b) als Dotierstoff Phosphor verwendet wird; und

(c) die Implantation des Phosphors mit einer Dosis von $10^{15}$ -$10^{16}$ Teilchen/cm$^2$ bei einer Beschleunigungsspannung von etwa 170 keV vorgenommen wird.

6. Verfahren nach Anspruch 5, dadurch gekennzeichnet, dass der Phosphor beim an die Implantation anschliessenden Diffusionsvorgang bis zu einer Tiefe von etwa 10 $\mu$m eingetrieben wird.

7. Verfahren nach Anspruch 6, dadurch gekennzeichnet, dass das Eintreiben des Phosphors in einer wasserhaltigen Atmosphäre bei einer Temperatur von etwa 1050 °C über eine Zeit von etwa 2 h erfolgt.

FIG.1A

FIG.1B

FIG.1C

FIG.1D

FIG.1F

FIG.1G

FIG.1 E

FIG. 1H

FIG. 1I

FIG. 1K

FIG. 2

| Var. | U/I n⁺ | $T_{AU}$ |
|------|--------|----------|
|      | ohm    | °C/60' |
| □    | .75    | 835–840 |
| +    | 2.6    | 835–846 |
| ◇    | 1.2    | 852–856 |

87/001

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 135 733 (CHADDA, MADAN MOHAN) * Seite 5, Zeile 24; Ansprüche 1,2 * --- | 1 | H 01 L 29/167 H 01 L 29/40 H 01 L 29/44 |
| A | PATENT ABSTRACTS OF JAPAN, Band 5, Nr. 91 (E-61)[763], 13. Juni 1981; & JP-A-56 37 671 (NIPPON DENKI K.K.) 11-04-1981 --- | 1 | |
| A | PATENT ABSTRACTS OF JAPAN, Band 8, Nr. 200 (E-266)[1637], 13. September 1984; & JP-A-59 89 460 (TOSHIBA K.K.) 23-05-1984 --- | 1 | |
| A | CH-A- 657 478 (BROWN-BOVERI) * Anspruch 1; Figur 1 * --- | 1 | |
| A | EP-A-0 193 462 (THOMSON-CSF) * Spalte 6, Zeilen 34-42; Anspruch 4 * ----- | 1 | |

**RECHERCHIERTE SACHGEBIETE (Int. Cl.4)**

H 01 L 29

Der vorliegende Recherchenbericht wurde für alle Patentansprüche erstellt

| Recherchenort | Abschlußdatum der Recherche | Prüfer |
|---|---|---|
| DEN HAAG | 18-04-1988 | PELSERS L. |